Europäisches Patentamt

European Patent Office

Office européen des brevets

(19)

(11) Publication number: **0 072 209**
**A2**

## EUROPEAN PATENT APPLICATION

(21) Application number: 82304139.7

(22) Date of filing: 05.08.82

(51) Int. Cl.³: **G 11 C 17/00,** H 01 L 27/10, H 01 L 21/76

(30) Priority: 08.08.81 JP 124582/81

(71) Applicant: **FUJITSU LIMITED, 1015, Kamikodanaka Nakahara-ku, Kawasaki-shi Kanagawa 211 (JP)**

(43) Date of publication of application: 16.02.83 **Bulletin 83/7**

(72) Inventor: **Ueno, Kouji, 1360, Shukugawara Tama-ku, Kawasaki-shi Kanagawa 214 (JP)**

(74) Representative: **Rackham, Stephen Neil et al, GILL JENNINGS & EVERY 53/64 Chancery Lane, London WC2A 1HN (GB)**

(84) Designated Contracting States: **DE FR GB**

(54) Junction short-circuiting-type programmable read-only memory device.

(57) A junction short-circuiting-type programmable read-only memory (PROM) device comprises a plurality of striped buried layers (12) with a plurality of striped collector regions (13) on them. A plurality of base regions (15-0 to 15-5) are arranged in a row, with one in each of the collector regions, and, in addition, an emitter region (16-0 to 16-5) is arranged in each base region. Further, in each of the collector regions, a plurality of high impurity regions (17′-1 to 17′-3) of the same conductivity type as that of the collector region are formed to connect the collector region to the word lines and each base region is connected to a bit line. One of the high impurity regions are provided for each two base regions which avoids variations in the separation of the memory cells and the collector connections and consequent variations in the write-in current, and, in addition, decreases the resistance between the emitter and collector so that the area of the memory cells can be reduced with a consequent increase in the integration density of the memory device.

1

FUJITSU LIMITED

"JUNCTION SHORT-CIRCUITING-TYPE PROGRAMMABLE READ-ONLY
  MEMORY DEVICE"

The present invention relates to a junction short-
-circuiting-type programmable read-only memory (PROM)
device in which bipolar transistor technology is used.

In a typical junction short-circuiting-type PROM
device, a memory cell, which has the same structure as a
conventional bipolar transistor, is located adjacent
each crossing point of the word lines and bit lines.
Each memory cell has its collector connected to its
adjacent word line, its emitted connected to its adjacent
bit line, and a floating-state base. When the memory cell
is of the NPN type, the write-in operation for this memory
cell is performed by supplying an excess current from the
emitter to the collector to break down or short-circuit
the PN junction between the emitter and the base. Therefore,
after this operation the written-in memory cell acts as
a diode.

In a first earlier type of structure of a PROM
device, a plurality of adjacent memory cells are connected
to a striped buried layer which is, in turn, connected
to the word line. The buried layer may be thought of as
a common collector region with a plurality of base regions
arranged within it with each base region including one
emitter region corresponding to a bit line. With such a
structure one collector electrode is connected to the buried
layer for every four to eight base regions, that is, for

2                    0072209

every four to eight memory cells.  As a result of the resistance of the buried layer the write-in current varies with the distance of the cell away from the collector electrode.  This means that the write-in current has to be greater than necessary and also the peripheral circuits have to be more complex than necessary.  In addition, the resistance between the emitter and collector of a memory cell also varies.  Therefore, to avoid an increase of the resistance between the emitter and collector of a memory cell, the area of the memory cell must be increased, thereby reducing integration density of the memory device.

Another earlier proposal for a PROM device is shown in Japanese Unexamined Patent Publication (Kokai) No. 55-55561.  This device does not include a striped buried layer and the write-in current does not vary in accordance with the position of a memory cell.  In this device two adjacent memory cells are arranged back-to-back so that they share a common collector electrode.  In this device, however, as compared with the first device, the manufacturing yield is reduced, and, in addition, the integration density is reduced.  Further, the access speed is reduced as will be explained in more detail subsequently.  Thus, overall the problems associated with this other proposal are greater than for the first.

In accordance with this invention the first earlier type of PROM device is modified by providing one collector electrode for each pair of adjacent base regions or for each two memory cells, thereby avoiding variation of the write-in current with variations in the separation of the memory cells and the collector electrodes, and, in addition, decreasing the resistance between the emitter and collector of the memory cell so that the area of the cells can be reduced with a consequent increase in the integration density of the memory cells.

A particular example of a device in accordance with this invention will now be described and contrasted with earlier devices with reference to the accompanying drawings, wherein:

Figure 1 is a block diagram of a typical junction short-circuiting-type PROM device;

Figure 2 is a plan of a first earlier type of junction short-circuiting-type PROM device;

Figure 3 is a cross-section taken along line III-III shown in Figure 2;

Figure 4 is a plan of a second earlier proposal for a junction short-circuiting PROM device;

Figure 5 is a cross-section taken along line V-V shown in Figure 4;

Figure 6 is a plan of the example of the junction short-circuiting PROM device in accordance with the present invention; and,

Figure 7 is a cross-section taken along line VII-VII shown in Figure 6.

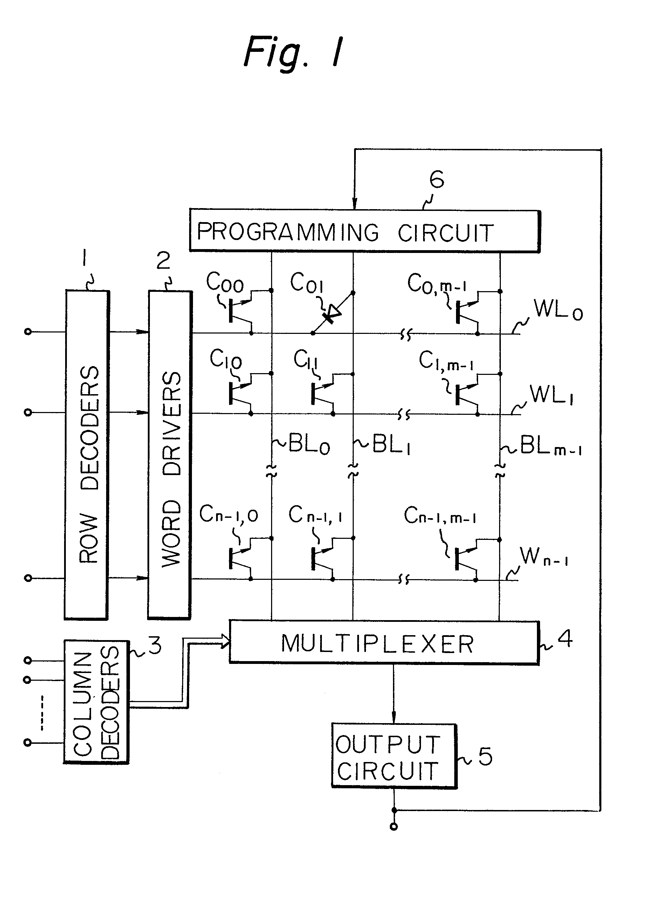

In Fig. 1, which illustrates a general junction short-circuiting-type PROM device, memory cells $C_{00}$ , $C_{01}$ , ..., $C_{0,m-1}$ , $C_{10}$ , $C_{11}$ , ..., $C_{1,m-1}$; ...; $C_{n-1,0}$ , $C_{n-1,1}$ , ..., and $C_{n-1,m-1}$ are arranged at the intersections of word lines $WL_0$ , $WL_1$ , ..., and $WL_{n-1}$ and bit lines $BL_0$ , $BL_1$ , ..., and $BL_{m-1}$. One of word lines $WL_0$ , $WL_1$ , ..., and $WL_{n-1}$ is selected by row decoders 1 and word drivers 2 while one of bit lines $BL_0$ , $BL_1$ , ..., and $BL_{m-1}$ is selected by column decoders 3 and multiplexer 4. Thus, the read-out data is output from output circuit 5. In this case, the conduction state or non-conduction state of a memory cell corresponds to data "1" or "0". In the write-in operation for a memory cell such as $C_{01}$ , programming circuit 6 supplies an excess current from bit line $BL_1$ through cell $C_{01}$ to word line $WL_0$ so as to short-circuit cell $C_{01}$ , that is, so as to break down the junction between the emitter and base of cell $C_{01}$ to cause a permarnent short-circuit therebetween. As a result, as illustrated in Fig. 1, cell $C_{01}$ serves as a diode.

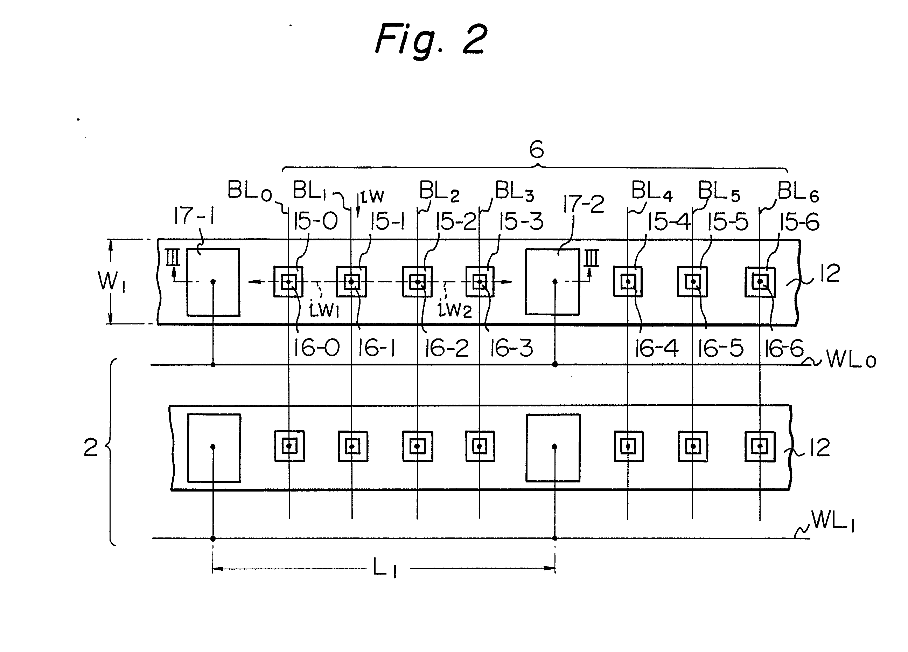

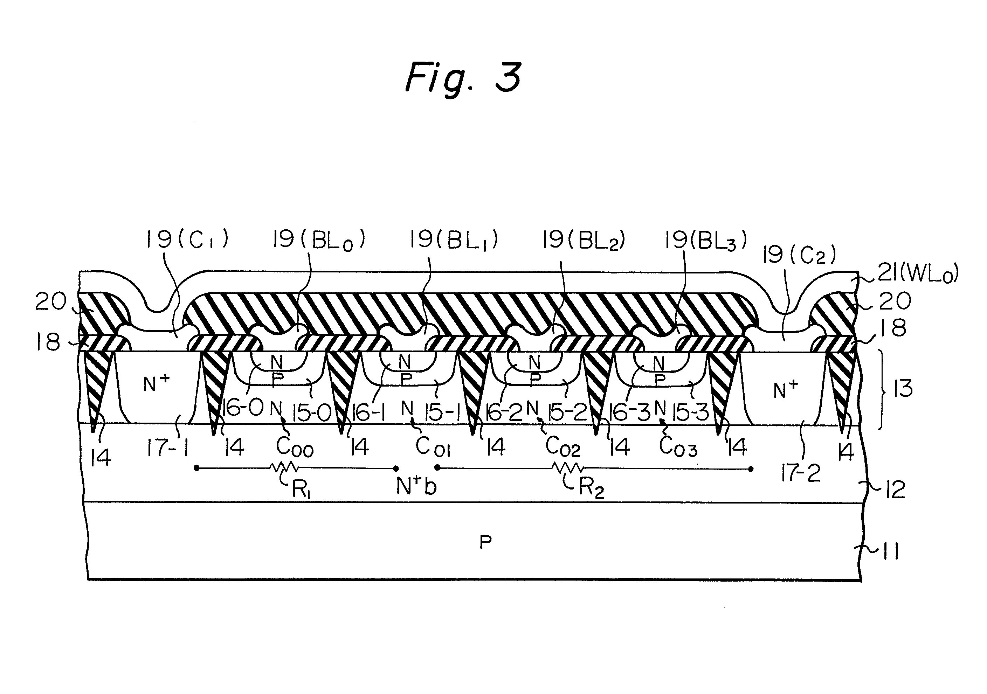

Figures 2 and 3 illustrate a first prior art junction short-circuiting-type PROM device, and reference numeral 11 of Fig. 3 designates a semiconductor substrate which is, for example, a P-type semiconductor substrate. On semiconductor substrate 11 are disposed $N^+$-type buried layer 12 and N-type epitaxial layer 13. Buried layer 12 is striped and corresponds to one word line $WL_0$ or $WL_1$. Epitaxial layer 13 serves as a collector region. In epitaxial layer 13, a plurality of V-groove isolation polycrystalline backfills (VIP) are formed by vertical anisotropic etching (V-ATE). In addition, in epitaxial layer 13, a plurality of P-type regions or base regions 15-0, 15-1, 15-2, and 15-3, ... are formed, and in each base region, N-type regions, or emitter regions, 16-0, 16-1, 16-2, and 16-3 are formed. Further, $N^+$-type regions 17-1, 17-2, ... are formed in epitaxial layer 13.

In Fig. 3, reference numeral 18 designates an isolation layer such as $SiO_2$; $19(C_1)$, $19(BL_0)$, $19(BL_1)$, $19(BL_2)$, $19(BL_3)$, and $19(C_2)$ designate first connection layers such as polycrystalline silicon; 20 designates an isolation layer such as phospho-silicate glass (PSG); and 21 designates a second connection layer such as aluminium. In more detail, connection layers $19(C_1)$ and $19(C_2)$ serve as collector electrodes; connection layers $19(BL_0)$, $19(BL_1)$, $19(BL_2)$, and $19(BL_3)$ serve as bit lines $BL_0$, $BL_1$, $BL_2$, and $BL_3$, respectively, of Fig. 2; and connection layer $21(WL_0)$ serves as word line $WL_0$ of Fig. 2.

In the structure of the PROM device of Figs. 2 and 3, since one collector electrode or region such as 17-1 is arranged for every four cells, there is a problem in that the write-in current fluctuates in accordance with the location of a cell.

For example, when writing is carried out in cell $C_{01}$, a reverse bias current $i_W$ is supplied from programming circuit 6 to the PN junction formed by emitter region 16-1 and base region 15-1, thereby breaking down the junction, that is, fixing the junction in the conduction state. In this case, however, as illustrated in Fig. 2, write-in current $i_W$ is shunted to the right and left sides ($i_{W1}$, $i_{W2}$) of emitter region 16-1 or base region 15-1. In other words, write-in current $i_W$ is dispersed, thereby reducing the concentration of write-in current $i_W$. This is because structurally the ratio of resistance $R_1$ (see Fig. 3) from cell $C_{01}$ to collector electrode $19(C_1)$ is roughly commensurate with resistance $R_2$ from cell $C_{01}$ to collector electrode $19(C_2)$

6                    0072209

that is, $R_1/R_2 \simeq 0.67$. This means a larger cirrent flow is necessary for short-circuiting of the junction of cell $C_{01}$. On the other hand, when writing is carried out in cell $C_{00}$, the write-in current is barely shunted, resulting in an excellent concentration of the write-in current, thereby enabling short-circuiting of the junction with a smaller current.

That is, there is a difference in the collector resistance (combined resistance) between cells $C_{00}$ and $C_{01}$, and, as a result, there is a difference in the write-in current between cells $C_{00}$ and $C_{01}$. Therefore, in order to avoid malfunctioning of the write-in operation, it is necessary to supply a larger write-in current in consideration of cell $C_{01}$ rather than $C_{00}$, which causes the peripheral circuits to be complex, and, in addition, reduces integration.

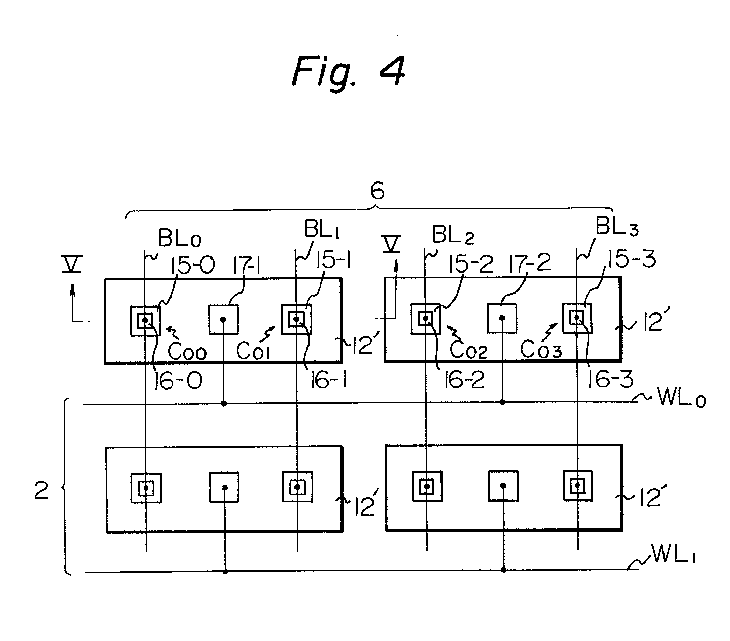

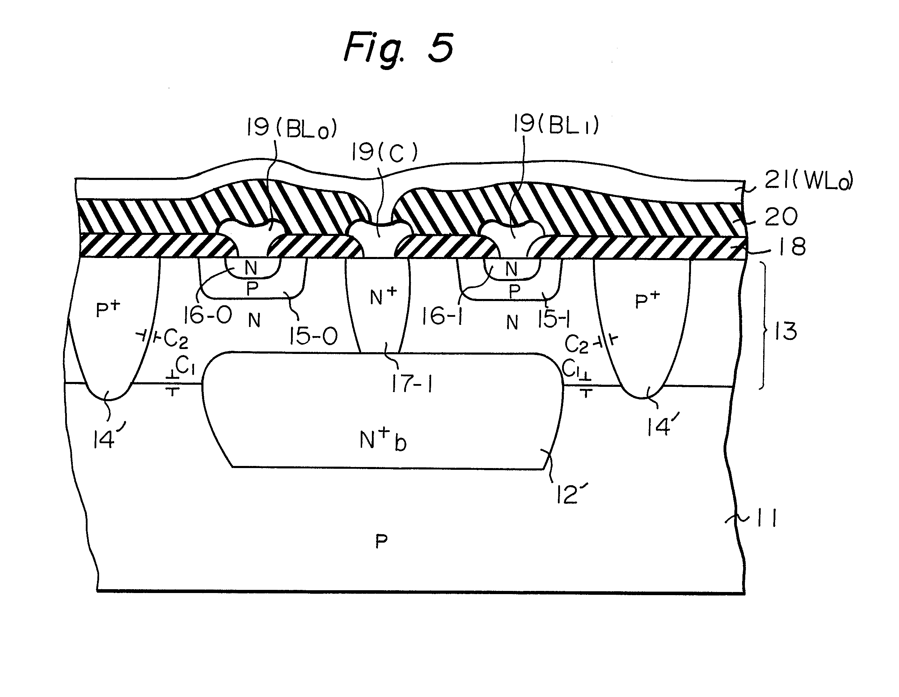

As means for solving such a problem in the structure of Figs. 2 and 3, another junction short-circuiting-type PROM device as illustrated by Figs. 4 and 5 is disclosed in Japanese Unexamined Patent Publication (Kokai) No. 55-55561. According to this structure, a collector region is formed by a short buried layer 12', a collector region 13 and one collector electrode 19(C) or $N^+$-type region such as 17-1 and two base regions such as 15-0 and 15-1. That is, a combination of cells $C_{00}$ and $C_{01}$ and a combination of cells $C_{02}$ and $C_{03}$ are arranged in a collector region over buried layer 12'. In such a structure, the write-in current is concentrated on only one side of each cell, thereby equalizing the write-in current in each cell.

In the structure of Figs. 4 and 5, however, an improvement of manufacturing yield, high integration, and high access speed cannot be expected. This will be explained in more detail.

First of all, as illustrated in Fig. 5, only one collector electrode 19(C) is provided in each collector region disposed over buried layer 12'. As a result, if there is a defect in the throughhole formed on insulating layer 18 for connecting $N^+$-type region 17-1 to collector electrode 19(C), the cell including such a defective throughhole cannot be saved since there is no other means for connecting the collector region to word line 21(WL$_0$). In general, as the capacity of a PROM device is increased so as to have a high density, the manufacturing yield of such a throughhole is remarkably reduced. In addition, it is necessary to isolate collector regions from each other electrically, in the word line direction as well as in the bit line direction. This is accomplished by the provision of isolation diffusion regions 14'. However, these regions create a harmful effect in respect to high integration density.

Further, due to the presence of junction capacitance $C_1$ between the collector regions and substrate 11, junction capacitance $C_2$ between the collector regions and isolation diffusion regions 14', and the like, the load capacity of word line 21(WL$_0$) connected to all such capacitances is remarkably increased and thereby the access speed of the PROM device is reduced.

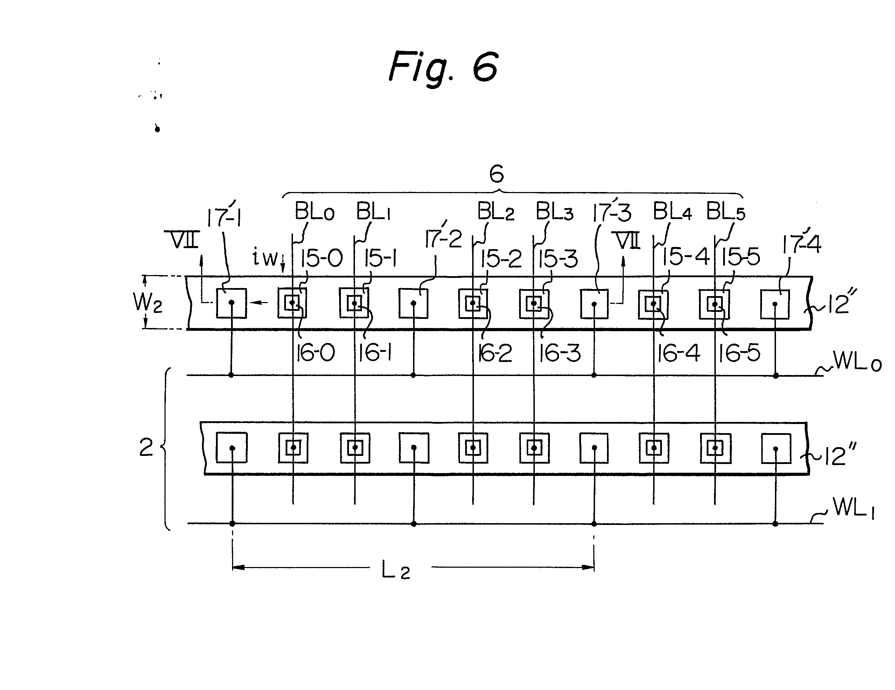

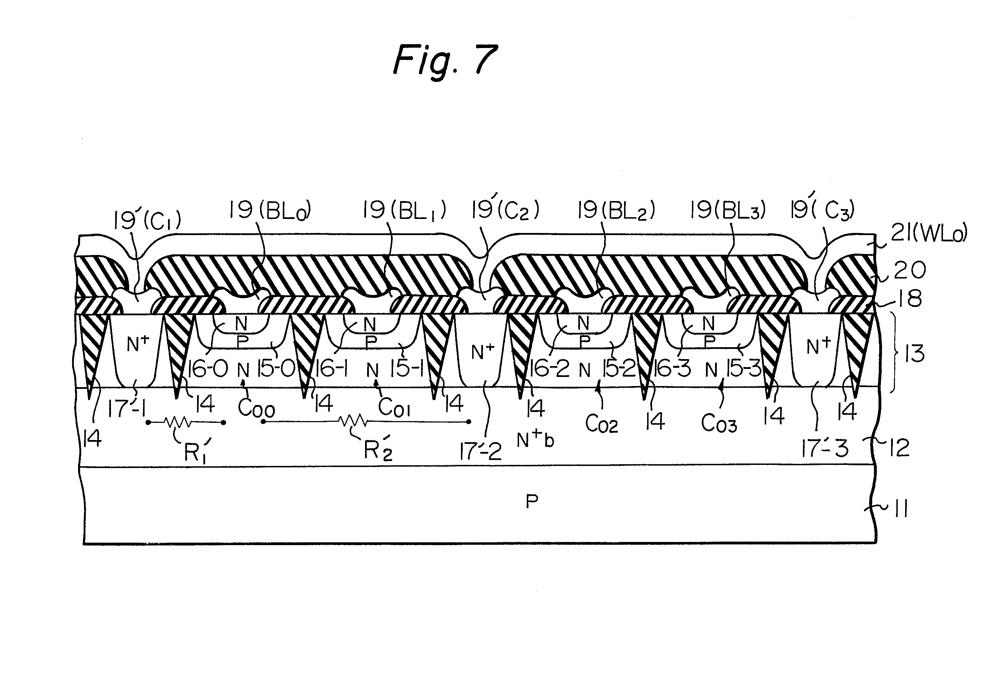

Figures 6 and 7 illustrate an embodiment of the present invention. One collector electrode such as 19'(C$_1$) or one $N^+$-type region such as 17'-1 is provided for every two memory cells while in the prior art device of Figs. 2 and 3 one collector electrode such as 19(C$_1$) or one $N^+$-type region such as 17-1 is provided for every four memory cells.

The present invention is now compared with the prior art of Figs. 2 and 3.

First of all, in the present invention, since one collector electrode such as 19'(C$_1$), 19'(C$_2$) or 19'(C$_3$) is arranged every two cells, the write-in current does not fluctuate in accordance with the location of a cell, and, in addition, a concentrated write-in current is effectively generated. For example, when writing is carried out in memory cell C$_{00}$, write-in current $i_W$ supplied from bit line BL$_0$ flows mainly to the side of $N^+$-type region 17'-1 (collector electrode 19'(C$_1$)) since the difference between

resistance $R_1'$ (see Fig. 7) from cell $C_{00}$ to collector electrode 19'($C_1$) and resistance $R_2'$ from cell $C_{00}$ to collector electrode 19'($C_2$) is very large, that is, $R_1'/R_2' \cong 0.06$. Note that such a ratio of the prior art is about 0.67. Therefore, in the present invention, no substantial dispersion of the write-in current is generated, thereby effectively enabling breakdown or short-circuiting of a cell.

In addition, the present invention is advantageous as compared with the prior art of Figs. 2 and 3 in that integration density is high. That is, due to the fact that all the cells are close to a corresponding collector electrode such as 19'($C_1$), the combined collector resistance, which is almost the same in all the cells, is very small. As a result, width $W_2$ of the collector region or buried layer 12" can be reduced as in the prior art of Figs. 2 and 3. Therefore, although an increase of collector electrodes may increase length $L_2$ for every four cells, a high integration can be obtained, for example

$$W_2 \cong 0.6W_1$$
$$L_2 \cong 1.1L_1$$

Therefore, $W_2L_2 \cong 0.66W_1L_1$ can be expected and thereby the size of a cell can be reduced.

The present invention is now compared with the prior art of Figs. 4 and 5.

First of all, in the present invention, the manufacturing yield is improved. As mentioned above, a higher integration is obtained, and the manufacturing yield of throughholes formed on insulating layer 18 is reduced. In the present invention, however, even when there is a defective throughhole for connecting one collector region to a corresponding word line, the collector region may be connected to the word line through another throughhole. That is, since a plurality of collector electrodes are provided in each collector region, the write-in current can be supplied and the read-out operation can be performed by using another throughhole, thereby compensating for such a defective throughhole. Therefore, the memory cells are saved in spite of having a defective throughhole, thereby improving the manufacturing yield.

In addition, no isolation diffusion regions 14' such as those of the prior art are necessary, thereby minimizing the distance between the cells. Further, there are no junction capacitances $C_1$ and $C_2$ such as those of the prior art mentioned above, and the load capacity of a word line is reduced, thereby enabling a high access speed.

Note that, in this embodiment, an isolation region between the striped collector regions formed by epitaxial layer 13 is also formed by using VIP (not shown). Of course, buried layer 12" for forming a common collector region is also striped. Further, the presence of a VIP between the cells can prevent latching-up of parasitic PNPN thyristors therebetween. Furthermore, diffusion layers designated by 15-0, 16-0, 17'-1, and the like can be manufactured by self-alignment due to the presence of such VIP, which is beneficial in respect to high integration density.

However, it should be noted that such VIP can be omitted in the device of Fig. 7.

Thus, according to the present invention, the write-in current fluctuation in accordance with the location of a cell is improved, and, in addition, the write-in current concentration at the junction of a cell is improved without reducing the manufacturing yield, high integration density, and high access speed.

CLAIMS

1. A junction short-circuiting-type programmable read-only memory (PROM) device comprising:

a plurality of word lines ($WL_0$ to $W_{n-1}$);

a plurality of bit lines ($BL_0$ to $BL_{m-1}$);

a semiconductor substrate (11) of a first conductivity type;

a plurality of first collector regions each comprising a striped buried layer (12) having a high concentration of impurities of a second conductivity type opposite to the first conductivity type and formed on the semiconductor substrate;

a plurality of second collector regions (13) of the second conductivity type, each of the second collector regions being formed on one of the striped buried layers;

a plurality of base regions (15-0 to 15-5) of the first conductivity type arranged in a row within each of the second collector regions;

a plurality of emitter regions (16-0 to 16-5) of the second conductivity type being arranged within the base regions and connected to the bit lines; and,

a plurality of word line contact regions of the second conductivity type connected to the word lines, characterised in that a word line contact region (17'-1 to 17'-3) is provided for each pair of adjacent base regions.

2. A device according to claim 1, further comprising a plurality of V-groove isolation regions (14) disposed adjacent the base regions and to the high impurity regions.

3.  A device according to claim 2, wherein the V-groove isolation regions comprise V-groove isolation polycrystalline backfills.

4.  A device according to any one of the preceding claims, wherein each of the word line cont-act regions comprises a high impurity concentration region of the second conductivity type extending to the striped buried layer.

5.  A junction short-circuiting-type programmable read-only memory (PROM) device comprising:

a plurality of word lines ($WL_O$ to $W_{n-1}$);

a plurality of bit lines ($BL_O$ to $BL_{m-1}$);

a semiconductor substrate (11) of a first conductivity type;

a plurality of first collector regions each comprising a striped buried layer (12) having a high concentration of impurities of a second conductivity type opposite to said first conductivity type and formed on said semiconductor substrate;

a plurality of second collector regions (13) of said second conductivity type, each of said second collector regions being formed on one of said striped buried layers;

a plurality of base regions (15-0 to 15-5) of said first conductivity type disposed in a row within each of said second collector regions;

a plurality of emitter regions (16-0 to 16-5) of said second conductivity type, each being disposed within one of said base regions and connected to one of said bit lines;

a plurality of word line contact regions (17'-1 to 17'-3) of said second conductivity type, each being disposed for every two adjacent base regions and connected to one of said word lines.

# Fig. 1

Fig. 2

# Fig. 3

Fig. 3

# Fig. 4

Fig. 5

0072209

Fig. 6

*Fig. 7*